Europäisches Patentamt

European Patent Office

Office européen des brevets

(19)

(11) **EP 1 191 651 A1**

(12) # EUROPEAN PATENT APPLICATION

(43) Date of publication:
**27.03.2002  Bulletin 2002/13**

(51) Int Cl.⁷: **H01S 5/12**

(21) Application number: **01121269.3**

(22) Date of filing: **05.09.2001**

(84) Designated Contracting States:
**AT BE CH CY DE DK ES FI FR GB GR IE IT LI LU
MC NL PT SE TR**
Designated Extension States:
**AL LT LV MK RO SI**

(30) Priority: **06.09.2000  JP 2000270571**

(71) Applicant: **NEC CORPORATION
Tokyo (JP)**

(72) Inventor: **Huang, Yidong
Minato-ku, Tokyo (JP)**

(74) Representative: **Glawe, Delfs, Moll
Patentanwälte
Postfach 26 01 62
D-80058 München (DE)**

(54)  **Distributed feedback semiconductor laser**

(57)     A distributed feedback semiconductor laser includes a semiconductor substrate (101), a diffraction grating (103), an optical guide layer (110), an active layer (104), a cladding layer (105), first and second electrodes (107,108), and an antireflection coating film (109). The diffraction grating (103) is formed on the semiconductor substrate (101) and constitutes a resonator. The diffraction grating has a $\lambda/4$ phase-shift region (102) for changing a phase of light by $\lambda/4$. The optical guide layer (110) is formed on the diffraction grating (103). The active layer (104) is formed on the optical guide layer (110) to correspond to a region other than the $\lambda/4$ phase-shift region (102). The cladding layer (105) is formed on the active layer (104) and the optical guide layer (110). The first electrode (107) is formed on the cladding layer (105) through a cap layer (106). The second electrode (108) is formed on a lower surface of the semiconductor substrate (101) and adapted to cause distributed feedback of light. The antireflection coating film (109) is formed on each of front and rear end faces of the resonator.

FIG. 1

EP 1 191 651 A1

## Description

Background of the Invention

The present invention relates to a phase-shift distributed feedback semiconductor laser with a high mode stability, which is suitably used in, e.g., a digital optical transmission system.

Conventionally, a digital optical transmission system uses a semiconductor laser with high single mode properties, which is called a $\lambda/4$ phase-shift distributed feedback semiconductor laser or Distributed FeedBack Laser Diode (DFB-LD) in which the phase of a diffraction grating is shifted by half cycle at the center of the laser resonator. The structure of $\lambda/4$ phase shift is described in, e.g., Fig. 12 · 12 of "Semiconductor Laser", THE INSTITUTE OF APPLIED PHYSICS, pp. 270 - 237, October 1994.

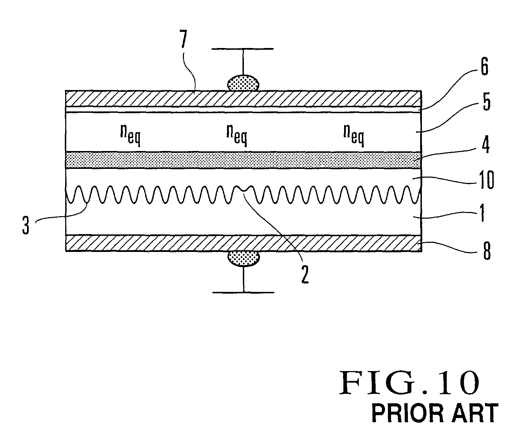

Fig. 10 shows the structure of a conventional DFB-LD seen from the longitudinal direction of the resonator. Referring to Fig. 10, a diffraction grating 3 with a $\lambda/4$ phase-shift region 2 at the center of the resonator is formed on a semiconductor substrate 1. An optical guide layer 10, active layer 4, cladding layer 5, and cap layer 6 are sequentially formed on the diffraction grating 3. Electrodes 7 and 8 are formed on the outer sides of the cap layer 6 and semiconductor substrate 1, respectively.

With the conventional $\lambda/4$ phase-shift DFB-LD, when direct modulation is to be performed, as the carrier density in the active layer 4 fluctuates, the equivalent refractive index of the $\lambda/4$ phase-shift region 2 changes, and spectral spreading such as dynamic wavelength shift or wavelength chirping occurs. Therefore, when long-distance optical fiber transmission is to be performed, as the optical fiber has finite wavelength dispersion, the transmission distance is limited by the spectral width of the light source.

Summary of the Invention

It is an object of the present invention to provide a DFB-LD in which fluctuation of the oscillation wavelength in direct modulation is suppressed and wavelength chirping is decreased.

In order to achieve the above object, according to the present invention, there is provided a distributed feedback semiconductor laser comprising a semiconductor substrate, a diffraction grating formed on the semiconductor substrate and constituting a resonator, the diffraction grating having a $\lambda/4$ phase-shift region for changing a phase of light by $\lambda/4$, an optical guide layer formed on the diffraction grating, an active layer formed on the optical guide layer to correspond to a region other than the $\lambda/4$ phase-shift region, a cladding layer formed on the active layer and the optical guide layer, a first electrode formed on the cladding layer through a cap layer, a second electrode formed on a lower surface of the semiconductor substrate and adapted to cause distributed feedback of light, and an antireflection coating film formed on each of front and rear end faces of the resonator.

Brief Description of the Drawings

Fig. 1 is a partially cutaway perspective view showing the structure of a DFB-LD according to the first embodiment of the present invention;

Fig. 2 is a sectional view of the DFB-LD of Fig. 1 seen from the longitudinal direction of the resonator;

Figs. 3A and 3B are graphs for explaining a change in phase shift amount caused by direct modulation;

Fig. 4A shows oscillation wavelength obtained with the DFB-LD of the present invention when the equivalent refractive index increases ($n_{2eq} > n_{1eq}$) due to direct modulation;

Fig. 4B shows oscillation wavelength obtained with the DFB-LD of the present invention when the equivalent refractive index decreases ($n_{2eq} < n_{1eq}$) due to direct modulation;

Fig. 4C shows wavelength chirping in a conventional DFB-LD caused by direct modulation;

Fig. 5 is a partially cutaway perspective view showing the structure of a DFB-LD according to the second embodiment of the present invention;

Fig. 6 is a partially cutaway perspective view showing the structure of a DFB-LD according to the third embodiment of the present invention;

Fig. 7 is an enlarged sectional view of the main part of the DFB-LD shown in Fig. 6;

Fig. 8 is a partially cutaway perspective view showing the structure of a DFB-LD according to the fourth embodiment of the present invention;

Fig. 9 is an enlarged sectional view of the main part of the DFB-LD shown in Fig. 8; and

Fig. 10 is a sectional view of the conventional DFB-LD seen from the longitudinal direction of the resonator.

Description of the Preferred Embodiments

First, the principle of the present invention will be described.

A Bragg wavelength $\lambda_B$ of a diffraction grating is determined by the pitch and equivalent refractive index of the diffraction grating, and is expressed by equation (1):

$$\lambda_B = 2_{neq} 1 \qquad (1)$$

where neq indicates the equivalent refractive index and Λ indicates the pitch of the diffraction grating.

The amount of λ/4 phase shift formed at the center of the resonator is expressed by equation (2):

$$\sigma = \lambda_B/4_{neq} = \Lambda / 2 \qquad (2)$$

When direct modulation is to be performed with the DFB-LD, the equivalent refractive index of the resonator fluctuates due to fluctuations in the electric field and carrier density in the laser, which are caused by a modulation signal.

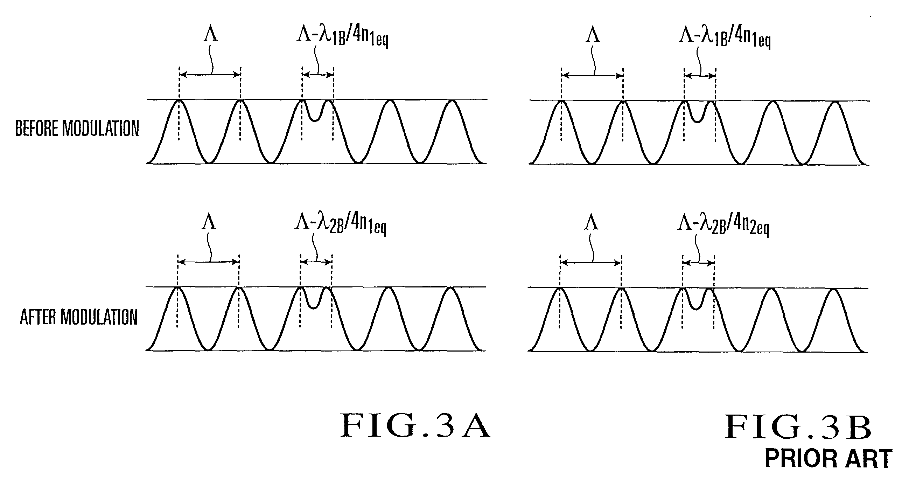

In the conventional DFB-LD, as shown in Fig. 3B, when the equivalent refractive index changes from $n_{1eq}$ to $n_{2eq}$ due to direct modulation, the Bragg wavelength also changes from $\lambda_{1B} = 2n_{1eq}\Lambda$ to $\lambda_{2B} = 2n_{2eq}\Lambda$. As the Bragg wavelength is proportional to a change in equivalent refractive index, the phase shift amount is $\sigma = \lambda_{1B}/4n_{1eq} = \lambda_{2B}/4n_{2eq} = \Lambda/2$, which is the same as λ/4.

In the DFB-LD of the present invention, no active layer is formed on the λ/4 phase-shift region. Hence, as shown in Fig. 3A, even when the carrier density in the active layer changes due to direct modulation, the equivalent refractive index of the λ/4 phase-shift region stays at $n_{1eq}$ and does not change. The Bragg wavelength is proportional to the equivalent refractive index of the uniform diffractive grating portion where the active layer is formed, in the same manner as in the conventional DFB-LD. When the equivalent refractive index changes from $n_{1eq}$ to $n_{2eq}$, the Bragg wavelength changes from $\lambda_{1B} = 2n_{1eq}\Lambda$ to $\lambda_{2B} = 2n_{2eq}\Lambda$. However, since the equivalent refractive index $n_{1eq}$ of the λ/4 phase-shift region does not change, the phase shift amount changes from $\sigma = \lambda_{1B}/4n_{1eq}$ to $\sigma = \lambda_{2B}/4n_{1eq}$.

Therefore, with the DFB-LD of the present invention, the phase shift amount dynamically changes during direct modulation. This fluctuation in phase shift amount has a locking effect over the oscillation wavelength, so that the fluctuation of the oscillation wavelength can be suppressed.

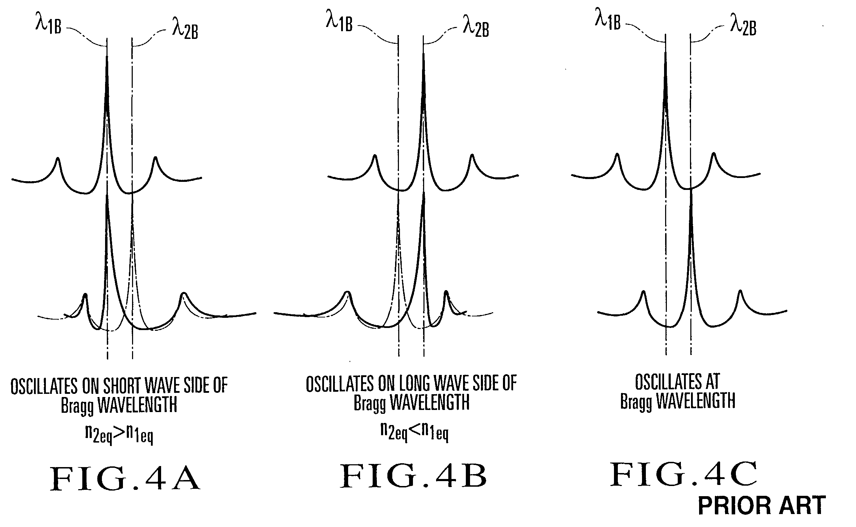

The wavelength locking effect with the DFB-LD of the present invention will be described in detail with reference to Figs. 4A to 4C. As is known well, a λ/4 phase-shift DFB-LD oscillates at the Bragg wavelength located at the center of the stop band, and a laser with a phase shift amount larger than λ/4 oscillates on the short wave side of the stop band. Conversely, a laser with a phase shift amount smaller than λ/4 oscillates on the long wave side of the stop band.

Fig. 4C shows waveform chirping of the conventional DFB-LD caused by direct modulation. The DFB-LD oscillates at the Bragg wavelength. When the Bragg wavelength changes from $\lambda_{1B}$ to $\lambda_{2B}$ due to direct modulation, the oscillation wavelength also changes from $\lambda_{1B}$ to $\lambda_{2B}$, and wavelength chirping occurs.

Fig. 4A shows oscillation wavelength obtained with the DFB-LD of the present invention when the equivalent refractive index increases ($n_{2eq} > n_{1eq}$) due to direct modulation. As the equivalent refractive index increases, the Bragg wavelength increases ($\lambda_{2B} > \lambda_{1B}$), and the phase shift amount ($\sigma = \lambda_{2B}/4n_{1eq} > \lambda_{1B}/4n_{1eq} = \Lambda/2$) also increases to exceed λ/4. Hence, the oscillation wavelength becomes off the Bragg wavelength which is increasing (changing to the long wavelength side), and moves to the short wavelength side of the stop band.

Fig. 4B shows oscillation wavelength obtained with the DFB-LD of the present invention when the equivalent refractive index decreases ($n_{2eq} < n_{1eq}$) due to direct modulation. As the equivalent refractive index decreases, the Bragg wavelength decreases ($\lambda_{2B} < \lambda_{1B}$), and the phase shift amount ($\sigma = \lambda_{2B}/4n_{1eq} < \lambda_{1B}/4n_{1eq} = \Lambda/2$) also decreases to be smaller than λ/4. Hence, the oscillation wavelength becomes off the Bragg wavelength which is decreasing (changing to the short wavelength side), and moves to the long wavelength side of the stop band.

With the DFB-LD of the present invention, different from the prior art in which the oscillation wavelength of the conventional DFB-LD changes as the Bragg wavelength changes, when the equivalent refractive index of the λ/4 phase-shift region is fixed in direct modulation, as the phase shift amount fluctuates, a locking effect over the oscillation wavelength can be obtained. When the Bragg wavelength changes to the long wavelength side, the oscillation wavelength becomes off the Bragg wavelength that has changed, and the DFB-LD oscillates at a wavelength shorter than it. When the Bragg wavelength changes to the short wavelength side, the oscillation wavelength becomes off the Bragg wavelength that has changed, and the DFB-LD oscillates at a wavelength longer than it. Accordingly, the fluctuation in oscillation wavelength during direct modulation can be suppressed, so that a low-chirp DFB-LD can be realized.

The present invention will be described in detail with reference to the accompanying drawings.

The accompanying drawings merely schematically show the sizes, shapes, and positional relationships of the respective structural components to a degree that enables understanding of the present invention. Therefore, the present invention is not limited to those shown in the drawings.

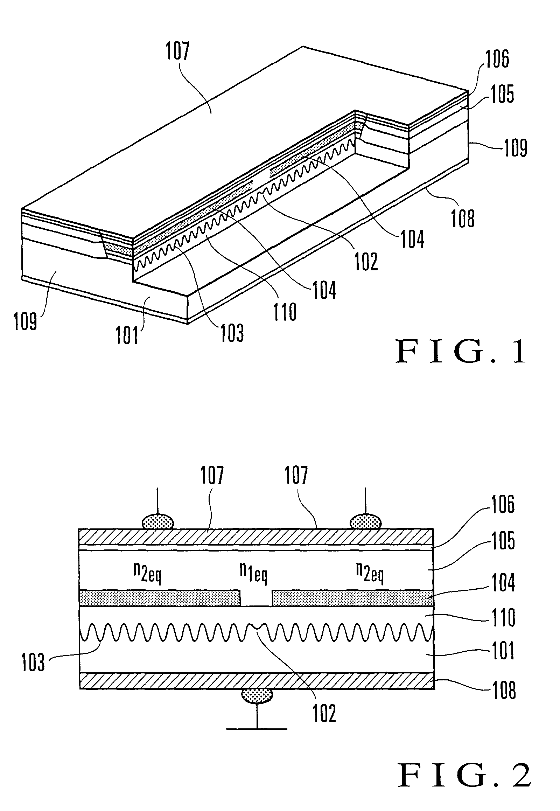

Figs. 1 and 2 show the structure of a DFB-LD according to an embodiment of the present invention. Referring to Figs. 1 and 2, a diffraction grating 103 which has a λ/4 phase-shift region 102 at the center of the resonator to cause distributed feedback of light is formed on an InP semiconductor substrate 101. An optical guide layer 110 constituting an optical waveguide, an active layer 104 for generating light, a cladding layer 105 for trapping light, and a cap layer 106 are sequentially formed on the diffraction grating 103. An electrode 107 is formed on the cap layer 106, and an electrode 108 is formed on the lower surface of the semiconductor substrate 101. Antireflection coating films 109 are formed on the front and rear end faces, respectively, of the DFB-LD.

The DFB-LD described above is different from the conventional DFB-LD in that the active layer 104 is formed on a region excluding the $\lambda/4$ phase-shift region 102. In other words, the active layer 104 is not formed on the $\lambda/4$ phase-shift region 102.

The DFB-LD of this embodiment has a resonator length of 300 $\mu$m, and is manufactured by the following method.

First, the diffraction grating 103 with the $\lambda/4$ phase-shift region 102 is formed on the InP semiconductor substrate 101 by known electron beam exposure and known lithography. The optical guide layer 110 made of InGaAsP is formed on the diffraction grating 103 to a thickness of 0.1 $\mu$m. The active layer 104 formed of a 7-layered compression strain quantum well (well: 7 x 6 nm, barrier layer: 5 x 10 nm) is selectively formed on the optical guide layer 110 to correspond to the diffraction grating 103 in a region other than the $\lambda/4$ phase-shift region 102.

The cladding layer 105 made of InGaAsP is formed on the active layer 104 and optical guide layer 110 to a thickness of 3 $\mu$m, and the cap layer 106 made of InP is formed on the cladding layer 105 to a thickness of 0.2 $\mu$m. The electrodes 107 and 108 are formed on the cap layer 106 and on the lower surface of the InP semiconductor substrate 101, respectively, by a known electrode forming method. Then, the antireflection coating films 109 are formed on the front and rear end faces of the DFB-LD. In this manufacturing method, the etching depth for forming the diffraction grating 103 is set to 0.03 $\mu$m so that a distributed feedback coupling coefficient $\kappa$ becomes about 70/cm. The period of the diffraction grating 103 is 240.0 nm.

In the DFB-LD with the above arrangement, since the active layer 104 is not formed on the $\lambda/4$ phase-shift region 102, even when carrier injection into the active layer 104 fluctuates, the equivalent refractive index of the $\lambda/4$ phase-shift region 102 does not change. As described concerning the principle of the present invention, the phase shift amount is changed by a direct modulation signal and has a locking effect over oscillation wavelength. As a result, a low-chirp DFB-LD can be realized.

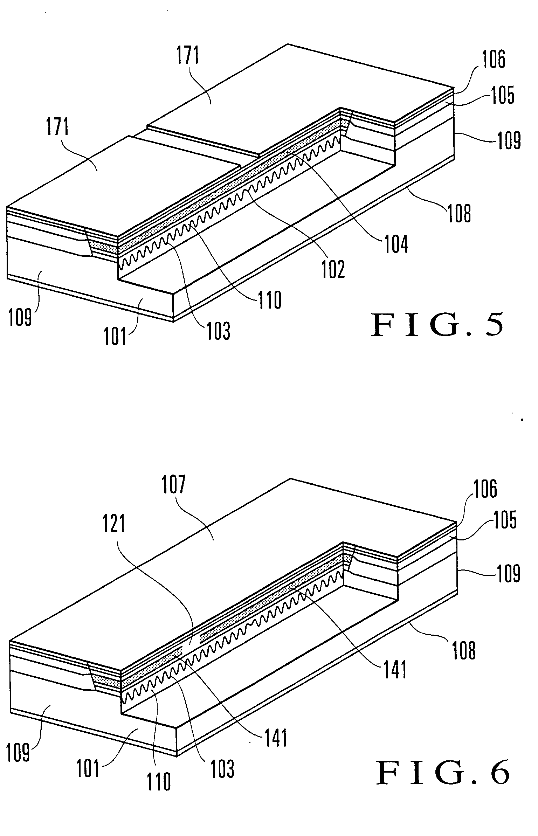

Fig. 5 shows the structure of a DFB-LD according to the second embodiment of the present invention.

This embodiment is different from the first embodiment in that an electrode 171 is formed on a cap layer 106 to correspond to a region other than a $\lambda/4$ phase-shift region 102. More specifically, the electrode 171 is not formed at a portion corresponding to the $\lambda/4$ phase-shift region 102.

An active layer 104 is formed on the entire surface of an optical guide layer 110. In the same manner as in the first embodiment, the active layer 104 need not be formed at a portion corresponding to the $\lambda/4$ phase-

shift region 102. In place of the electrode 171, an electrode 108 may be formed at a region other than the $\lambda/4$ phase-shift region 102.

The DFB-LD of this embodiment has a resonator length of 300 $\mu$m, and is manufactured by the following method. First, a diffraction grating 103 with the $\lambda/4$ phase-shift region 102 is formed on an InP semiconductor substrate 101 by known electron beam exposure and known lithography. The 0.1-$\mu$m thick InGaAsP optical guide layer 110, the active layer 104 formed of a 7-layered compression strain quantum well (well: 7 x 6 nm, barrier layer: 5 x 10 nm), a 3-$\mu$m thick InGaAsP cladding layer 105, and the 0.2-$\mu$m thick InP cap layer 106 are sequentially formed on the InP semiconductor substrate 101 having the diffraction grating 103.

With a known electrode forming method, the electrode 171 is formed on the InP cap layer 106 to correspond to a region other than the $\lambda/4$ phase-shift region 102, and the electrode 108 is formed on the lower surface of the InP semiconductor substrate 101. Then, antireflection coating films 109 are formed on the front and rear end faces of the DFB-LD. The etching depth for forming the diffraction grating 103 is set to 0.03 $\mu$m so that a distributed feedback coupling coefficient $\kappa$ becomes about 70/cm. The period of the diffraction grating 103 is 240.0 nm.

In the DFB-LD with the above arrangement, since the electrode 171 is not formed to correspond to the $\lambda/4$ phase-shift region 102, carrier injection into the active layer 104 does not substantially occur. Therefore, in direct modulation, even if carrier injection fluctuates, the equivalent refractive index of the $\lambda/4$ phase-shift region 102 does not change. As described concerning the principle of the present invention, the phase shift amount is changed to have a locking effect over oscillation wavelength. Therefore, a DFB-LD which is low-chirp in direct modulation can be realized.

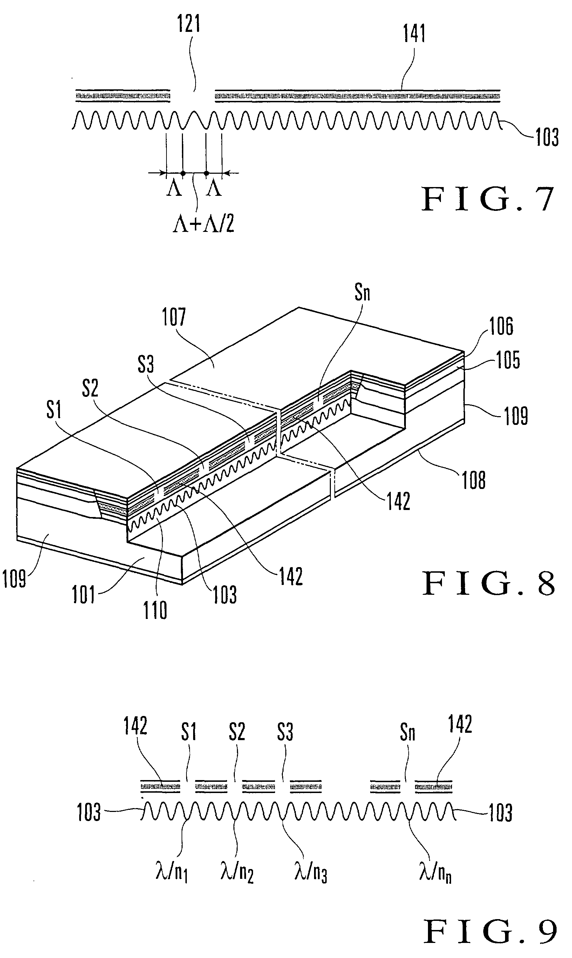

Figs. 6 and 7 show the structure of a DFB-LD according to the third embodiment of the present invention.

This embodiment is different from the first embodiment in that a $\lambda/4$ phase-shift region that has been formed at the center of the resonator in the first embodiment is formed at a position 1/4 the length of the resonator from the front end face. In the DFB-LD of this embodiment, as shown in Fig. 6, a $\lambda/4$ phase-shift region 121 is at a position 1/4 the length of the resonator from the front end face. An active layer 141 corresponds to a region other than the $\lambda/4$ phase-shift region 121, as shown in Fig. 7. The internal electric field is largely distributed near the $\lambda/4$ phase-shift region 121.

According to this embodiment, since the $\lambda/4$ phase-shift region 121 is formed at a position 1/4 the length of the resonator from the front end face, the field strength near the front end face increases, so the low-chirping characteristics are improved and the output efficiency of the DFB-LD can be improved.

Figs. 8 and 9 show the structure of a DFB-LD according to the fourth embodiment of the present invention.

This embodiment is different from the first embodiment in that a λ/4 phase-shift region is divided into a plurality of phase-shift regions. In the DFB-LD of this embodiment, the resonator is divided into a plurality of regions, as shown in Fig. 8. As shown in Fig. 9, phase-shift regions S1, S2, S3,..., and Sn are formed for each resonator region such that the entire phase shift becomes λ/4, and an active layer 142 is formed to correspond to regions other than the phase-shift regions S1, S2, S3,.., and Sn.

In the conventional DFB-LD, the electric field is distributed nonuniform and becomes strong at the center (or at the phase-shift region), so spatial hole burning tends to occur. According to this embodiment, the low chirping characteristics can be improved, and simultaneously the uniformity of the electric field distribution in the laser resonator can be improved.

In the above DFB-LDs according to the first to fourth embodiments, the active layer 104 is formed of a 7-layered compression strain quantum well (compression strain MQW). However, the present invention is not limited to this. For example, a tensile strain quantum well can be used.

As has been described above, according to the present invention, when the equivalent refractive index of the λ/4 phase-shift region is fixed in direct modulation, the phase shift amount changes, so a locking effect over the oscillation wavelength can be obtained.

When the Bragg wavelength changes to the long wavelength side, the oscillation wavelength becomes off the Bragg wavelength that has changed, and the DFB-LD oscillates at a wavelength shorter than it. When the Bragg wavelength changes to the short wavelength side, the oscillation wavelength becomes off the Bragg wavelength that has changed, and the DFB-LD oscillates at a wavelength longer than it. Accordingly, fluctuation in oscillation wavelength during direct modulation can be suppressed, so that a low-chirp DFB-LD can be realized.

**Claims**

1. A distributed feedback semiconductor laser **characterized by** comprising:

   a semiconductor substrate (101);
   a diffraction grating (103) formed on said semiconductor substrate and constituting a resonator, said diffraction grating having a λ/4 phase-shift region (102) for changing a phase of light by λ/4;
   an optical guide layer (110) formed on said diffraction grating;
   an active layer (104) formed on said optical guide layer to correspond to a region other than the λ / 4 phase-shift region;
a cladding layer (105) formed on said active layer and said optical guide layer;
a first electrode (107) formed on said cladding layer through a cap layer (106);
a second electrode (108) formed on a lower surface of said semiconductor substrate and adapted to cause distributed feedback of light; and
an antireflection coating film (109) formed on each of front and rear end faces of the resonator.

2. A laser according to claim 1, wherein at least one of said first and second electrodes is formed to correspond to a region other than the λ/4 phase-shift region.

3. A laser according to claim 1, wherein the λ/4 phase-shift region is formed of a plurality of divisional phase-shift regions (S1 - Sn).

4. A laser according to claim 1, wherein the λ/4 phase-shift region is formed at the center of the resonator.

5. A laser according to claim 1, wherein the λ/4 phase-shift region is formed at a position 1/4 a length of the resonator from the front end face of the resonator.

F I G . 1

F I G . 2

EP 1 191 651 A1

$\Lambda$    $\Lambda-\lambda_{1B}/4n_{1eq}$                $\Lambda$    $\Lambda-\lambda_{1B}/4n_{1eq}$

BEFORE MODULATION

$\Lambda$    $\Lambda-\lambda_{2B}/4n_{1eq}$                $\Lambda$    $\Lambda-\lambda_{2B}/4n_{2eq}$

AFTER MODULATION

# FIG.3A                FIG.3B
## PRIOR ART

$\lambda_{1B}$ $\lambda_{2B}$

$\lambda_{1B}$ $\lambda_{2B}$

$\lambda_{1B}$ $\lambda_{2B}$

OSCILLATES ON SHORT WAVE SIDE OF
Bragg WAVELENGTH

$n_{2eq} > n_{1eq}$

**FIG.4A**

OSCILLATES ON LONG WAVE SIDE OF
Bragg WAVELENGTH

$n_{2eq} < n_{1eq}$

**FIG.4B**

OSCILLATES AT
Bragg WAVELENGTH

**FIG.4C**
**PRIOR ART**

F I G . 5

F I G . 6

FIG.7

FIG.8

FIG.9

FIG.10
PRIOR ART

**European Patent Office**

## EUROPEAN SEARCH REPORT

Application Number

EP 01 12 1269

### DOCUMENTS CONSIDERED TO BE RELEVANT

| Category | Citation of document with indication, where appropriate, of relevant passages | Relevant to claim | CLASSIFICATION OF THE APPLICATION (Int.Cl.7) |
|---|---|---|---|
| X | PATENT ABSTRACTS OF JAPAN vol. 011, no. 288 (E-542), 17 September 1987 (1987-09-17) -& JP 62 086781 A (FUJITSU LTD), 21 April 1987 (1987-04-21) | 1,4 | H01S5/12 |
| Y | * abstract * | 1-3,5 | |
| X | PATENT ABSTRACTS OF JAPAN vol. 011, no. 195 (E-518), 23 June 1987 (1987-06-23) -& JP 62 023186 A (NEC CORP), 31 January 1987 (1987-01-31) * abstract * | 1,2,4 | |
| Y | US 6 043 104 A (UCHIDA MAMORU ET AL) 28 March 2000 (2000-03-28) * column 1 - column 2; figure 30 * | 1,2 | |
| Y | EP 0 289 250 A (NIPPON TELEGRAPH & TELEPHONE) 2 November 1988 (1988-11-02) * figures 4,5C * | 1,3 | |
| Y | PATENT ABSTRACTS OF JAPAN vol. 011, no. 092 (E-491), 24 March 1987 (1987-03-24) -& JP 61 242092 A (FUJITSU LTD), 28 October 1986 (1986-10-28) * abstract * | 1,5 | TECHNICAL FIELDS SEARCHED (Int.Cl.7) H01S |
| A | PATENT ABSTRACTS OF JAPAN vol. 010, no. 248 (E-431), 26 August 1986 (1986-08-26) -& JP 61 077381 A (NEC CORP), 19 April 1986 (1986-04-19) * abstract * | 1 | |

-/--

The present search report has been drawn up for all claims

| Place of search | Date of completion of the search | Examiner |
|---|---|---|
| MUNICH | 30 October 2001 | Gnugesser, H |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

**European Patent Office**

# EUROPEAN SEARCH REPORT

Application Number

EP 01 12 1269

## DOCUMENTS CONSIDERED TO BE RELEVANT

| Category | Citation of document with indication, where appropriate, of relevant passages | Relevant to claim | CLASSIFICATION OF THE APPLICATION (Int.Cl.7) |
|---|---|---|---|
| A | TAKAHIRO NUMAI: "1.5-UM WAVELENGTH TUNABLE PHASE-SHIFT-CONTROLLED DISTRIBUTED FEEDBACK LASER" JOURNAL OF LIGHTWAVE TECHNOLOGY, IEEE. NEW YORK, US, vol. 10, no. 2, 1 February 1992 (1992-02-01), pages 199-205, XP000267491 ISSN: 0733-8724 * I. Introduction * * fig. 1 * | 1 | |
| | | | TECHNICAL FIELDS SEARCHED (Int.Cl.7) |

The present search report has been drawn up for all claims

| Place of search | Date of completion of the search | Examiner |
|---|---|---|
| MUNICH | 30 October 2001 | Gnugesser, H |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

EP 1 191 651 A1

**ANNEX TO THE EUROPEAN SEARCH REPORT
ON EUROPEAN PATENT APPLICATION NO.**

EP 01 12 1269

This annex lists the patent family members relating to the patent documents cited in the above-mentioned European search report.
The members are as contained in the European Patent Office EDP file on
The European Patent Office is in no way liable for these particulars which are merely given for the purpose of information.

30-10-2001

| Patent document cited in search report | | Publication date | Patent family member(s) | | Publication date |
|---|---|---|---|---|---|
| JP 62086781 | A | 21-04-1987 | NONE | | |
| JP 62023186 | A | 31-01-1987 | NONE | | |
| US 6043104 | A | 28-03-2000 | JP | 10070341 A | 10-03-1998 |
| | | | JP | 10075016 A | 17-03-1998 |
| | | | US | 6075799 A | 13-06-2000 |
| EP 0289250 | A | 02-11-1988 | JP | 1231390 A | 14-09-1989 |
| | | | JP | 2563196 B2 | 11-12-1996 |
| | | | JP | 63269592 A | 07-11-1988 |
| | | | DE | 3873398 D1 | 10-09-1992 |
| | | | DE | 3873398 T2 | 18-03-1993 |
| | | | EP | 0289250 A2 | 02-11-1988 |
| | | | US | 4847856 A | 11-07-1989 |
| JP 61242092 | A | 28-10-1986 | NONE | | |
| JP 61077381 | A | 19-04-1986 | JP | 1931812 C | 12-05-1995 |
| | | | JP | 6056904 B | 27-07-1994 |

For more details about this annex : see Official Journal of the European Patent Office, No. 12/82